# EUROPEAN PATENT SPECIFICATION

(11) **EP 4 274 037 B1**
(45) Date of publication and mention of the grant of the patent: **28.01.2026**
(21) Application number: 22187806.9
(22) Date of filing: 29.07.2022
(51) Int. Cl.: H01S 3/067, H01S 3/094, H01S 3/0941, H01S 3/1115, H01S 3/1118, H01S 3/08022, H01S 3/1112, H01S 3/08036, H01S 3/08, H01S 3/16

(54) **ALL-FIBER LASER OSCILLATOR GENERATING ULTRASHORT PULSES AND ITS APPLICATIONS**
GANZFASER-LASEROSZILLATOR ZUR ERZEUGUNG ULTRAKURZER IMPULSE UND SEINE ANWENDUNGEN
OSCILLATEUR LASER TOUT-FIBRE GÉNÉRANT DES IMPULSIONS ULTRA-COURTES ET SES APPLICATIONS

(30) Priority: 05.05.2022 PL 44110222
(43) Date of publication of application: 08.11.2023
(73) Proprietor: Instytut Chemii Fizycznej PAN, 01-224 Warszawa (PL)
(72) Inventor: PIELACH, Mateusz, 20-153 Lublin (PL); JAMROZIK, Agnieszka, 30-205 Krakow (PL); KRUPA, Katarzyna, 05-070 Sulejowek (PL); STEPANENKO, Yuriy, 01-494 Warszawa (PL)
(74) Representative: JD&P Patent Attorneys Joanna Dargiewicz & Partners

(56) References cited:
- EP-A1- 3 300 191
- CN-U- 208 461 198
- PL-B1- 235 842
- MATEUSZ PIELACH ET AL: "Studying the operation of an all-PM Yb-doped fiber laser oscillator at negative and positive net cavity dispersion", ARXIV.ORG, CORNELL UNIVERSITY LIBRARY, 201 OLIN LIBRARY CORNELL UNIVERSITY ITHACA, NY 14853, 11 January 2022 (2022-01-11), XP091137747
- HUANG FENGQIN ET AL: "Wide-Range Wavelength-Tunable Mode-Locked Fiber Laser Based on Fiber Bragg Grating", IEEE PHOTONICS TECHNOLOGY LETTERS, IEEE, USA, vol. 32, no. 17, 15 July 2020 (2020-07-15), pages 1025 - 1028, XP011801436, ISSN: 1041-1135, [retrieved on 20200728], DOI: 10.1109/LPT.2020.3009381
- L. YUN: "All-fiber laser simultaneously delivering multi-wavelength solitons", OPTICS COMMUNICATIONS, vol. 322, 2014, AMSTERDAM, NL, pages 61 - 65, XP055271057, ISSN: 0030-4018, DOI: 10.1016/j.optcom.2014.02.007
- IBARRA-ESCAMILLA ET AL: "Experimental investigation of self-starting operation in a F8L based on a symmetrical NOLM", OPTICS COMMUNICATIONS, ELSEVIER, AMSTERDAM, NL, vol. 281, no. 5, 20 November 2007 (2007-11-20), pages 1226 - 1232, XP022419518, ISSN: 0030-4018, DOI: 10.1016/J.OPTCOM.2007.10.075
- WANG-YUHL OH ET AL: "Passive Mode Locking of a Neodymium-Doped Fiber Laser with a Nonlinear Optical Loop Mirror", IEEE JOURNAL OF QUANTUM ELECTRONICS, IEEE, USA, vol. 32, no. 2, February 1996 (1996-02-01), XP011051313, ISSN: 0018-9197
- CHEN HE ET AL: "0.4[mu]J, 7kW ultrabroadband noise-like pulse direct generation from an all-fiber dumbbell-shaped laser", OPTICS LETTERS, vol. 40, no. 23, 18 November 2015 (2015-11-18), US, pages 5490, XP093045617, ISSN: 0146-9592, DOI: 10.1364/OL.40.005490

## Description

This invention relates to the field of ultrafast laser technologies. This patent document discloses a semi-linear configuration of an all-fiber laser oscillator, especially made entirely out of polarization-maintaining (PM) fibers. The pulsed operation is achieved via passive mode-locking with a nonlinear optical loop mirror (NOLM).

The possibility of generating a stable pulse train in harsh environments is the main advantage of lasers made entirely out of PM fibers compared to standard configurations that incorporate free-space elements. Sources based on PM fibers are more resistant to mechanical vibrations and temperature changes. Moreover, they can also work in high humidity or dust *[*W. Hänsel, H. Hoogland, M. Giunta, S. Schmid, T. Steinmetz, R. Doubek, P. Mayer, S. Dobner, C. Cleff, M. Fischer, and R. Holzwarth. All polarization-maintaining fiber laser architecture for robust femtosecond pulse generation. Applied Physics B, 123,11.2016*;* X. Shen, W. Li, and H. Zeng. Polarized dissipative solitons in all-polarization-maintained fiber laser with long-term stable self-started mode-locking. Applied Physics Letters, 105: 101109-101109 , 09 2014*].*

Thanks to that, such systems are widely used in applications outside of research laboratories, e.g., in such areas as: medicine, imaging *[*M. Brinkmann, A. Fast, T. Hellwig, I. Pence, CL Evans, and C. Fallnich. Portable all-fiber dual-output widely tunable light source for coherent Raman imaging. Biomed. Opt. Express , 10 (9): 4437 - 4449, Sep 2019*]* or material processing *[*T. Szymborski, Y. Stepanenko, K. Niciński, P. Piecyk, SM Berus, M. Adamczyk-Poplawska, and A. Kamińska. Ultrasensitive SERS platform made via femtosecond laser micromachining for biomedical applications. Journal of Materials Research and Technology, 12: 1496-1507, 2021*].*

Pulses of durations shorter than 10 ps can be obtained via passive mode-locking, which can be realized using material or artificial saturable absorbers. However, the former tend to lose their properties over time *[*K. Viskontas, K. Regelskis, and N. Rusteika. Slow and fast optical degradation of the SESAM for fiber laser mode-locking at 1 µm. Lithuanian Journal of Physics , 54: 127-13570, 05 2014*].* Because of that, in order to ensure the long-term stable performance of the laser, artificial saturable absorbers are preferred. The most frequently used methods are nonlinear polarization evolution (NPE) *[PL235842B1 Saturated absorber and the method* of *synchronizing the modes in the laser* *https:*//*patents.google.com*/*patent*/*pl235842b1]*, nonlinear optical loop mirror (NOLM) *[*NJ Doran and David Wood. Nonlinear-optical loop mirror. Opt. Lett. , 13 (1): 56-58 , Jan 1988*]* and the nonlinear amplifying loop mirror (NALM) *[*ME Fermann, F. Haberl, M. Hofer, and H. Hochreiter. Nonlinear amplifying loop mirror. Opt. Lett. , 15 (13): 752-754 , Jul 1990*].*

Most of the so far presented oscillators built out of PM fibers have possessed ring cavity. The most popular structures include figure-eight lasers *[*Irl N. Duling. All-fiber ring soliton laser mode locked with a nonlinear mirror. Opt. Lett. , 16 (8): 539-541, Apr 1991*;* JW Nicholson and M. Andrejco. A polarization maintaining, dispersion managed, femtosecond figure-eight fiber laser. Opt. Express , 14 (18): 8160-8167, Sep 2006*]* and figure-nine lasers *[*N. Kuse, J. Jiang, C.-C. Lee, TR Schibli, and ME Fermann. All polarization-maintaining Er fiber-based optical frequency combs with nonlinear amplifying loop mirror. Opt. Express , 24 (3): 3095-3102 , Feb 2016*].* Ring cavity oscillators are characterized by a single pass through the gain medium during one pulse roundtrip through the cavity. The main advantage of linear configurations is the double pass through the gain medium, which can reduce the length of the gain medium in the form of rare-earth-doped fiber. When using a configuration utilizing NALM or NOLM loop, it is impossible to implement a fully linear configuration. The hybrid solutions with a fragment of a linear cavity are still characterized by a single pulse pass through the gain medium during one roundtrip through the cavity *[*VI Denisov, AV Ivanenko, BN Nyushkov, and Viktor Pivtsov. Femtosecond fiber laser with a hybrid linear - ring cavity. Quantum Electronics, 38: 801-802,09 2008*].*

There has also been proposed a setup mode-locked via NALM, which incorporates two fragments of rare-earth-doped fibers. However, in the presented setup, the pulse passes through one fragment of the doped fiber two times during one roundtrip and only once through the second gain medium, which is placed inside the NALM loop. [F. Graf, R. Scelle, H. Diekamp, A. Budnicki, and T. Dekorsy, "Femtosecond fiber oscillator based on a 3×3-coupler-NALM: numerical model and realizations at 1 and 2 µm," Opt. Express 30, 12555-12564 (2022)]. Fully linear configurations require reflective elements in the cavity, which can be achieved with a material saturable absorber in the form of a SESAM (semiconductor saturable absorber mirror) *[*D. Yan, B. Liu, J. Guo, M. Zhang, Y. Chu, Y. Song, and M. Hu. Route to stable dispersion-managed mode-locked Yb-doped fiber lasers with near-zero net cavity dispersion. Opt. Express, 28(20):29766-29774, Sep 2020*],* which does not guarantee the long-term stability of such an oscillator. Another way is to use a linear cavity in the Mamyshev oscillator. However, it requires a seed pulse to initiate the pulsed operation *[*EP3178137B1 *Method and generator for generating ultra-short light pulses* *https:*//*patents.google.com*/*patent*/*ep3178137b1*]. Using the NPE, it is possible to implement a linear configuration via a Faraday mirror, which introduces a free-space that reduces environmental stability of the system *[*PL235842B1 *Saturated absorber and mode synchronization in the laser* *https:*//*patents.google.com*/*batent*/*pl235842b1 ;* EP1720223A1 *Environmentally stable self-starting mode-locked waveguide laser and a method of generating mode-locked laser pulses* *https:*//*patents.google.com*/*patent*/*ep1720223a1*/*en ;* M. Yu, Z. Cheng, C. Hong, Y. Shi, Z. Peng, M. Wang, and P. Wang. Numerical modeling and experimental investigation of ultrafast pulses generation from all-polarization-maintaining dispersion-managed nonlinear polarization evolution Yb-doped fiber laser. Opt. Express, 28 (22): 32764-32776, Oct 2020*;* Guanyu Liu, Shangming Ou, Qingmao Zhang, Mingsi Zhang, Xiangping Li, and Qiaoliang Bao. All-polarization-maintaining linear fiber laser mode-locked by nonlinear polarization evolution with phase bias. Optics & Laser Technology, 142: 107160,2021*].*

Surprisingly, it turned out that by using a nonlinear optical loop mirror together with an optical circulator, it is possible to create a semi-linear configuration that can be made entirely out of PM optical fibers and fiberized components, in which the pulse passes through the rare earth doped fiber twice per one cavity cycle. The presented configuration does not have free-space elements, nor does it need a seed pulse to initiate the pulsed operation.

Thus, the object of the invention is a fiber laser oscillator as defined in claim 1.

Preferred embodiments of the invention are defined in the dependent claims.

The invention also relates, as defined in claim 9, to the use of a laser oscillator with a semi-linear cavity configuration as defined above for generating ultrashort pulses.

The ultrashort pulse all-fiber laser oscillator with a semi-linear configuration is characterized by a double pulse pass through the optical fiber doped with rare-earth ions in one cycle through the cavity.

The section of the active ion-doped fiber is pumped through the wavelength division multiplexer (WDM) or a pump combiner.

The reflective element may be in the form of a fiber Bragg grating (FBG), especially a chirped fiber Bragg grating (CFBG), or a fiber loop mirror.

Pulsed operation is achieved via passive mode-locking using an artificial saturable absorber in the form of a nonlinear optical loop mirror (NOLM).

The cavity contains an optical circulator (CIR) integrating, via the ring cavity part, the nonlinear optical loop mirror with the linear part of the cavity.

Preferably, the optical circulator directs the beam amplified in the doped optical fiber to the input port of the nonlinear optical loop mirror.

Preferably, the optical circulator blocks the radiation reflected from the nonlinear optical loop mirror.

Preferably, the radiation transmitted by the nonlinear optical loop mirror is transmitted through the optical circulator to a port connected to the doped optical fiber.

In the preferred case, the chirped fiber Bragg grating acts as a compressor to reduce the chirp of the pulse.

In the preferred case of using a chirped fiber Bragg grating, the cavity contains an additional band-pass spectral filter, with parameters adjusted to the central wavelength of the radiation generated by the laser, which makes it possible to work in the regime of dispersion-managed dissipative soliton.

In a preferred case, the chirped fiber Bragg grating also acts as a spectral filter, enabling operation in the regime of dispersion-managed dissipative soliton without an additional band-pass spectral filter.

In a preferred case, the chirped fiber Bragg grating also acts as an output coupler, in which the radiation transmitted through the grating constitutes the output port.

In the preferred case of using chirped fiber Bragg grating, the WDM may be placed outside the cavity and constitute the output coupler.

In the case of using a fiber optic loop mirror, the cavity preferably includes a band-pass spectral filter, with parameters adjusted to the central wavelength of the laser-generated radiation, which enables operation in the dispersion-managed dissipative soliton regime.

In the preferred case of using a fiber optic loop mirror using a 2 x 2 coupler, one of the ports is the laser output port.

The present invention will be described in detail with reference to individual figures which present:

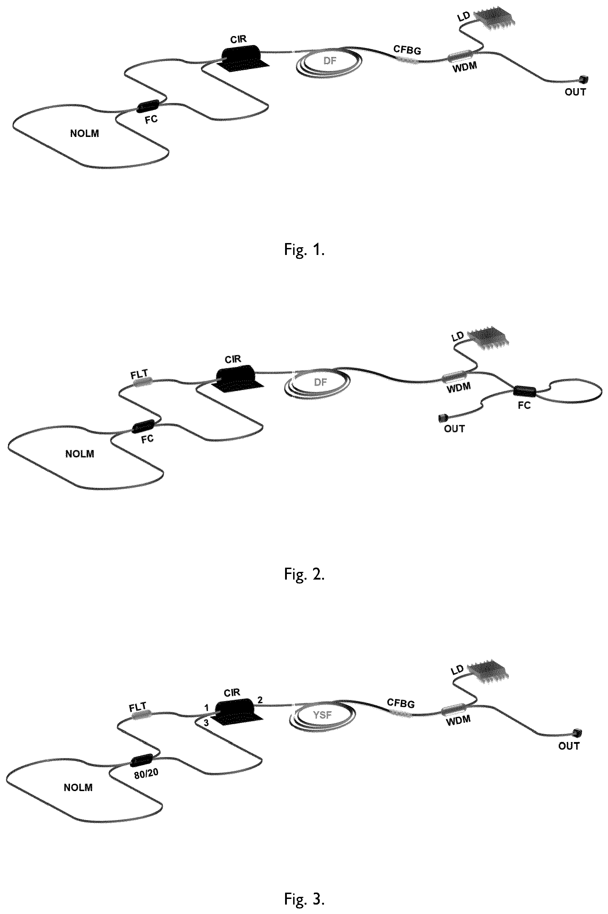

Fig. 1. A preferred semi-linear laser oscillator with a chirped fiber Bragg grating acting both as a reflective element and a spectral filter. LD - laser diode, WDM - wavelength division multiplexer, CFBG - chirped fiber Bragg grating, DF - optical fiber doped with rare-earth ions, CIR - optical circulator, FC - fiber coupler, NOLM - nonlinear optical loop mirror, OUT - output port.
Fig. 2. A preferred semi-linear laser oscillator system employing a fiber optic loop mirror as a reflective element. LD - laser diode, WDM - wavelength division multiplexer, DF - optical fiber doped with rare-earth ions, CIR - optical circulator, FLT - band-pass spectral filter, FC - fiber coupler, NOLM - nonlinear optical loop mirror, OUT - output port.
Fig. 3. A schematic diagram of an experimental laser oscillator with a semi-linear cavity configuration. LD - laser diode, WDM - wavelength division multiplexer, CFBG - chirped fiber Bragg grating, YSF - ytterbium-doped fiber, CIR - optical circulator (1, 2, 3 - circulator ports), FLT - band-pass spectral filter, 80 / 20 - fiber optic coupler with a power split ratio of 80 to 20, NOLM - nonlinear optical loop mirror, OUT - output port.

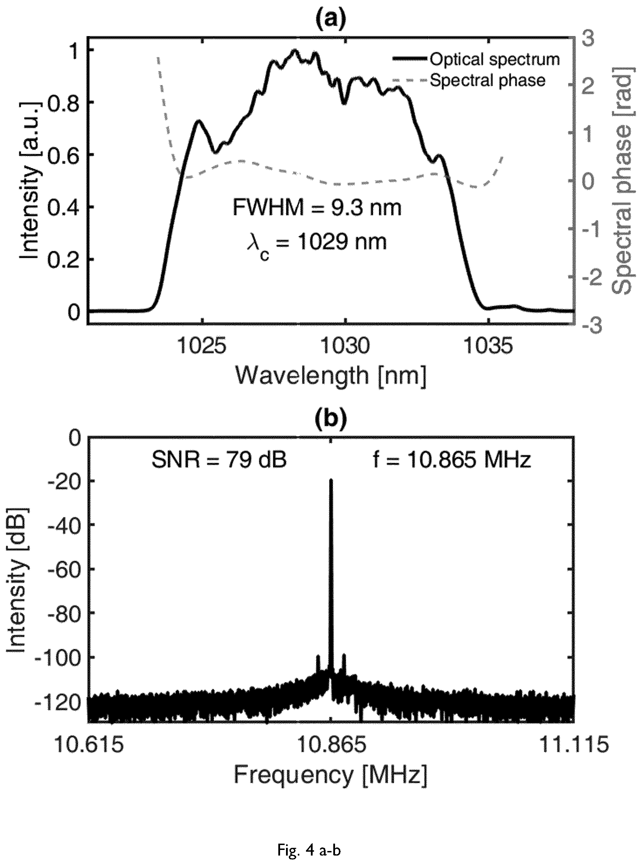

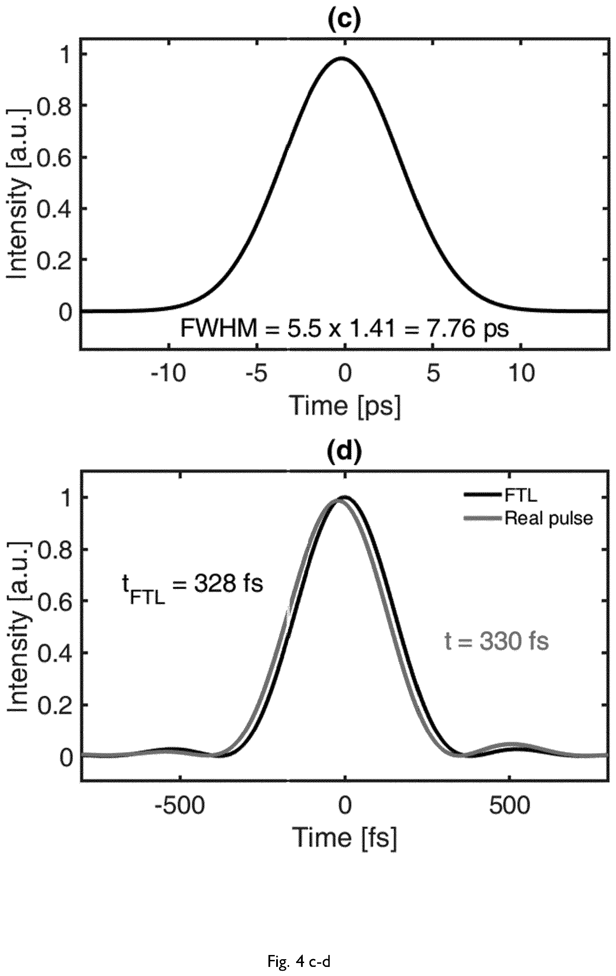

Fig. 4. Experimental spectral and temporal characteristics of an ultrafast fiber laser implemented according to the scheme in Fig. 3. The group delay dispersion of the described cavity is +0.324 ps².
   (a) Experimental optical spectrum (black curve) characterized by a central wavelength of 1029 nm with a full width at half maximum of 9.2 nm. The dashed curve shows the spectral phase of the compressed pulse, retrieved by the SPIDER method.
   (b) A radio frequency (RF) spectrum of an oscillator characterized by a repetition rate of 10.865 MHz.
   (c) Autocorrelation function of an output pulse having a duration of 5.5 ps.
   (d) Reconstructed compressed pulse duration (red curve, 330 fs) compared to Fourier transform-limited pulse (FTL, 328 fs, black curve).

Fig. 1 presents a preferred semi-linear laser oscillator setup. The gain medium in the form of a rare-earth-doped fiber (DF) is optically pumped through a pump coupler (WDM) using a laser diode (LD) with a wavelength adjusted to the absorption curve of the gain medium so that it is suitable for optical pumping. A chirped fiber Bragg grating (CFBG) acts simultaneously as a compressor, spectral filter, and reflective element. Due to the finite grating reflectance, it is possible to create an output port after the wavelength division multiplexer. The beam amplified in DF goes to the optical circulator (CIR), which is an element enabling the integration of a nonlinear optical loop mirror (NOLM) with a linear part of the cavity, resulting in a semi-linear oscillator configuration.

The circulator directs the radiation to the fiber optic coupler (FC) input port, which is used to implement the NOLM loop that guarantees the pulsed operation. CIR blocks the radiation reflected from the NOLM loop, while ensuring the transmission of radiation transmitted by the NOLM. After circulating through the NOLM loop and passing through the CIR, the pulse is again amplified in DF. Some radiation is reflected from the CFBG, which starts the subsequent pulse circulation through the resonator.

Preferably, a fiber optic loop mirror may also be used as the reflective element. An exemplary configuration is shown in Fig. 2. In this configuration, the WDM is placed inside the cavity. One of the loop mirror coupler's (FC) ports can be used as the output port. In order to guarantee the operation in the dissipative soliton regime, the cavity also contains a band-pass spectral filter (FLT).

### Example

An exemplary configuration of a semi-linear laser oscillator in accordance with the invention will be described below.

Fig. 3 presents a schematic diagram of an experimental setup that was built entirely of PANDA-type PM optical fibers. The gain medium in the form of a ytterbium-doped fiber (YSF) is pumped through a wavelength division multiplexer (WDM) using a laser diode (LD) with a central wavelength of 976 nm operating in a continuous wave mode. A chirped fiber Bragg grating (CFBG) acts as a reflective element that allows the creation of a fragment of a linear cavity.

In addition, CFBG introduces a negative group delay dispersion (-0.113 ps²) into the cavity, and also acts as a spectral filter with a center wavelength of 1030 nm and a full width at half maximum of 20 nm.

The amplified radiation after passing through the ytterbium-doped fiber goes to port 2 of the circulator, which provides high isolation (> 20 dB) in relation to port number 1 and low losses (<1 dB) in relation to port number 3. This means that the beam incident on port number 2 is directed to port 3 of the circulator. The next element is an artificial saturable absorber in the form of a NOLM loop based on a coupler with a power split ratio of 80 to 20. The beam reflected from the NOLM is blocked by a circulator that provides high isolation of the beam incident on port 3 in relation to port 2 (> 20 dB). The pulse that was transmitted by the NOLM is spectrally filtered by a band-pass spectral filter with a central wavelength of 1030 nm and a full width at half maximum of 6 nm, and then goes to port 1 of the circulator, which ensures low losses (<1 dB) in relation to port 2. Subsequently, the pulse propagates in the linear part of the cavity and is amplified again in the ytterbium-doped fiber. Then the pulse goes to the CFBG, on which it undergoes compression, spectral filtration, and reflection, which starts another pulse circulation through the cavity. Due to the finite value of the grating reflectance (12%), part of the radiation is transmitted by the CFBG, and goes to the WDM, which constitutes an output pulse. Fig. 4 shows the experimental spectral and temporal characteristics of the laser. The oscillator produces 5.5 ps pulses that can be compressed to 330 fs. An average power of 13.95 mW and a repetition rate of 10.865 MHz correspond to a pulse energy of 1.28 nJ.

Notably, the mentioned above additional band-pass spectral filter is an optional element, and its use, in this case, results from the mismatch of the spectral filtration characteristics of the used grating. Preferably, the spectral filtration of the used CFBG grating may be sufficient to obtain a dissipative soliton regime *[*M. Yu, Z. Cheng, C. Hong, Y. Shi, Z. Peng, M. Wang, and P. Wang. Numerical modeling and experimental investigation of ultrafast pulses generation from all-polarization-maintaining dispersion-managed nonlinear polarization evolution Yb-doped fiber laser. Opt. Express , 28 (22): 32764-32776, Oct 2020*;* M. Pielach, J. Szczepanek, K. Krupa and Y. Stepanenko, "Studying the Operation of an All-PM Yb-Doped Fiber Laser Oscillator at Negative and Positive Net Cavity Dispersion," in IEEE Access, vol. 10, pp. 45689-45694, 2022, doi: 10.1109/ACCESS.2022.3170921*].*

## Claims

1. A laser oscillator for generating ultrashort optical pulses with a semi-linear cavity configuration, having a ring cavity part and a linear cavity part, and containing a gain medium in the form of a rare-earth-doped fiber (DF) placed in the linear cavity part and configured to provide amplification of the ultrashort pulses twice per single cavity roundtrip, wherein said laser oscillator comprises a wavelength division multiplexer (WDM) or a pump combiner, and said rare-earth-doped fiber is configured to be optically pumped through the wavelength division multiplexer (WDM) or the pump combiner using a laser diode (LD) with a wavelength suitable for optical pumping, i.e., adapted to the maximal absorption of the gain medium absorption curve, the laser oscillator further comprising a reflective element and an output port (OUT), an optical circulator (CIR) integrating the ring cavity part with the linear cavity part, and a nonlinear optical loop mirror, NOLM, configured to be used for passive mode-locking, including a fiber coupler (FC) that has at least two input ports and at least two output ports and said laser oscillator is built entirely out of polarization-maintaining, PM, optical fibers and PM fiberized components.

2. The oscillator of claim 1, wherein the gain medium is in the form of a polarization-maintaining optical fiber and is doped with neodymium and / or erbium and / or ytterbium ions.

3. The oscillator of claim 1, or 2, wherein the reflective element makes it possible to form the linear part of the cavity.

4. The oscillator of claim 3, wherein the reflective element is a fiber Bragg grating (FBG), or a chirped fiber Bragg grating (CFBG), or a fiber loop mirror.

5. The oscillator as claimed in any one of claims 1 to 4, **wherein** it comprises an element acting as a spectral filter, preferably a fiber Bragg grating, or an additional band-pass spectral filter, with parameters adjusted to the central wavelength of the radiation generated by the laser.

6. The oscillator as claimed in any one of claims 1 to 5, **wherein** the output port (OUT) is formed by said WDM, wherein said WDM is an out-of-cavity wavelength division multiplexer (WDM), or a fiber optic coupler (FC), or a fiber Bragg grating.

7. The oscillator as claimed in any of claims 1 to 6, **wherein** the nonlinear optical loop mirror, NOLM, is configured to act as an artificial saturable absorber providing pulsed operation via passive mode-locking, and comprises said fiber coupler (FC) with at least 2 input ports and at least 2 output ports.

8. The oscillator of any one of claims 1 to 7, **wherein** the optical circulator (CIR) integrates, via the ring cavity part, the nonlinear optical loop mirror NOLM, with the linear part of the cavity so that it blocks the beam reflected from the NOLM, and transmits the beam transmitted through the NOLM.

9. Use of a laser oscillator with a semi-linear cavity configuration as defined in any one of claims 1 to 8 for generating ultrashort pulses.

## Patentansprüche

1. Laseroszillator zum Erzeugen ultrakurzer optischer Pulse mit einer semilinearen Hohlraumkonfiguration, der einen Ringhohlraumteil und einen linearen Hohlraumteil aufweist und ein Verstärkungsmedium in Form einer mit seltenen Erden dotierten Faser (DF) enthält, die in dem linearen Hohlraumteil angeordnet und konfiguriert ist, eine Verstärkung der ultrakurzen Impulse zweimal für jede Hohlraumumlaufzeit bereitzustellen, wobei der Laseroszillator einen Wellenlängenmultiplexer (WDM) oder einen Pump Combiner umfasst und die mit seltenen Erden dotierte Faser konfiguriert ist, um optisch durch den Wellenlängenmultiplexer (WDM) oder den Pump Combiner unter Verwendung einer Laserdiode (LD) mit einer Wellenlänge gepumpt zu werden, die für optisches Pumpen geeignet ist, d. h. an die maximale Absorption der Verstärkungsmediumabsorptionskurve angepasst ist, wobei der Laseroszillator ferner ein reflektierendes Element und einen Ausgangsanschluss (OUT), einen optischen Zirkulator (CIR), der den Ringhohlraumteil mit dem linearen Hohlraumteil integriert, und einen nichtlinearen optischen Schleifenspiegel, NOLM, umfasst, der konfiguriert ist, um für passives Modenkoppeln verwendet zu werden, einschließlich eines Faserkopplers (FC), der mindestens zwei Eingangsanschlüsse und mindestens zwei Ausgangsanschlüsse aufweist, und der Laseroszillator vollständig aus polarisationserhaltenden, PM, optischen Fasern und PM-faserverstärkten Komponenten aufgebaut ist.

2. Oszillator nach Anspruch 1, wobei das Verstärkungsmedium in Form einer polarisationserhaltenden optischen Faser vorliegt und mit Neodym- und/oder Erbium- und/oder Ytterbiumionen dotiert ist.

3. Oszillator nach Anspruch 1 oder 2, wobei das reflektierende Element ermöglicht, den linearen Teil des Hohlraums zu bilden.

4. Oszillator nach Anspruch 3, wobei das reflektierende Element ein Faser-Bragg-Gitter (FBG) oder ein Chirp-Faser-Bragg-Gitter (CFBG) oder ein Faserschleifenspiegel ist.

5. Oszillator nach einem der Ansprüche 1 bis 4, wobei er ein Element umfasst, das als Spektralfilter wirkt, vorzugsweise ein Faser-Bragg-Gitter oder ein zusätzliches spektrales Bandpassfilter, mit Parametern, die an die zentrale Wellenlänge der von dem Laser erzeugten Strahlung angepasst sind.

6. Oszillator nach einem der Ansprüche 1 bis 5, wobei der Ausgangsport (OUT) durch den WDM gebildet wird, wobei der WDM ein Out-of-Cavity-Wellenlängenmultiplexer (WDM) oder ein faseroptischer Koppler (FC) oder ein Faser-Bragg-Gitter ist.

7. Oszillator nach einem der Ansprüche 1 bis 6, wobei der nichtlineare optische Schleifenspiegel, NOLM, konfiguriert ist, um als künstlicher sättigbarer Absorber zu wirken, der gepulsten Betrieb über passives Modenkoppeln bereitstellt, und den Faserkoppler (FC) mit mindestens zwei Eingangsanschlüssen und mindestens zwei Ausgangsanschlüssen umfasst.

8. Oszillator nach einem der Ansprüche 1 bis 7, wobei der optische Zirkulator (CIR) über den Ringhohlraumteil den nichtlinearen optischen Schleifenspiegel, NOLM, mit dem linearen Teil des Hohlraums integriert, so dass er den vom NOLM reflektierten Strahl blockiert und den durch den NOLM übertragenen Strahl überträgt.

9. Verwendung eines Laseroszillators mit einer semilinearen Hohlraumkonfiguration nach einem der Ansprüche 1 bis 8 zum Erzeugen ultrakurzer Pulse.

## Revendications

1. Oscillateur laser destiné à produire des impulsions optiques ultracourtes avec une configuration de cavité semi-linéaire, présentant une partie de cavité annulaire et une partie de cavité linéaire, et contenant un milieu de gain sous la forme d'une fibre dopée aux terres rares (DF, *rare-earth-doped fiber*) placée dans la partie de cavité linéaire et configurée pour fournir une amplification des impulsions ultracourtes deux fois par cycle de cavité unique, dans lequel ledit oscillateur laser comprend un multiplexeur par répartition en longueur d'onde (WDM, *wavelength division multiplexer*) ou un combinateur de pompes, et ladite fibre dopée aux terres rares est configurée pour être pompée optiquement à travers le multiplexeur par répartition en longueur d'onde (WDM) ou le combinateur de pompes à l'aide d'une diode laser (LD, *laser diode*) avec une longueur d'onde appropriée pour un pompage optique, c'est-à-dire, adaptée à l'absorption maximale de la courbe d'absorption de milieu de gain, l'oscillateur laser comprenant en outre un élément réfléchissant et un port de sortie (OUT), un circulateur optique (CIR) intégrant la partie de cavité annulaire avec la partie de cavité linéaire, et un miroir en boucle optique non linéaire, NOLM (*nonlinear optical loop mirror*), configuré afin d'être utilisé pour un blocage de modes passif, y compris un coupleur de fibres (FC, *fiber coupler*) qui présente au moins deux ports d'entrée et au moins deux ports de sortie et ledit oscillateur laser est entièrement construit à partir de fibres optiques maintenant la polarisation, PM (*polarization-maintaining*), et de composants fibrés PM.

2. Oscillateur selon la revendication 1, dans lequel le milieu de gain se présente sous la forme d'une fibre optique maintenant la polarisation et est dopé avec des ions de néodyme et/ou d'erbium et/ou d'ytterbium.

3. Oscillateur selon la revendication 1 ou 2, dans lequel l'élément réfléchissant permet la formation de la partie linéaire de la cavité.

4. Oscillateur selon la revendication 3, dans lequel l'élément réfléchissant est un réseau de Bragg sur fibre (FBG, *fiber Bragg grating*) ou un réseau de Bragg sur fibre à compression (CFBG, *chirped fiber Bragg grating*) ou un miroir en boucle sur fibre.

5. Oscillateur selon l'une quelconque des revendications 1 à 4, dans lequel il comprend un élément agissant en tant que filtre spectral, de préférence un réseau de Bragg sur fibre, ou un filtre spectral passe-bande supplémentaire, avec des paramètres ajustés à la longueur d'onde centrale du rayonnement produit par le laser.

6. Oscillateur selon l'une quelconque des revendications 1 à 5, dans lequel le port de sortie (OUT) est formé par ledit WDM, dans lequel ledit WDM est un multiplexeur par répartition en longueur d'onde (WDM) hors cavité ou un coupleur optique de fibres (FC) ou un réseau de Bragg sur fibre.

7. Oscillateur selon l'une quelconque des revendications 1 à 6, dans lequel le miroir en boucle optique non linéaire, NOLM, est configuré pour agir en tant qu'absorbeur saturable artificiel fournissant un fonctionnement pulsé via un blocage de modes passif, et comprend ledit coupleur de fibres (FC) avec au moins deux ports d'entrée et au moins deux ports de sortie.

8. Oscillateur selon l'une quelconque des revendications 1 à 7, dans lequel le circulateur optique (CIR) intègre, via la partie de cavité annulaire, le miroir en boucle optique non linéaire, NOLM, avec la partie linéaire de la cavité de sorte qu'il bloque le faisceau réfléchi depuis le NOLM, et transmette le faisceau transmis à travers le NOLM.

9. Utilisation d'un oscillateur laser avec une configuration de cavité semi-linéaire telle que définie dans l'une quelconque des revendications 1 à 8 pour produire des impulsions ultracourtes.
